(19) Europäisches Patentamt
European Patent Office
Office européen des brevets

(11) **EP 3 013 999 B1**

(12) **EUROPÄISCHE PATENTSCHRIFT**

(45) Veröffentlichungstag und Bekanntmachung des Hinweises auf die Patenterteilung:
**09.08.2017 Patentblatt 2017/32**

(51) Int Cl.:
*C23C 18/06* (2006.01)     *C23C 18/12* (2006.01)
*C23C 18/14* (2006.01)     *C07F 5/00* (2006.01)

(21) Anmeldenummer: **14728954.0**

(22) Anmeldetag: **06.06.2014**

(86) Internationale Anmeldenummer:
**PCT/EP2014/061804**

(87) Internationale Veröffentlichungsnummer:
**WO 2014/206709 (31.12.2014 Gazette 2014/53)**

(54) **METALLOXID-PREKURSOREN, SIE ENTHALTENDE BESCHICHTUNGSZUSAMMENSETZUNGEN, UND IHRE VERWENDUNG**

METAL OXIDE PRECURORS, COATING COMPOSITIONS CONTAINING SAME, AND USE THEREOF

PRÉCURSEURS D'OXYDE MÉTALLIQUE, COMPOSITIONS DE REVÊTEMENT CONTENANT LESDITS PRÉCURSEURS D'OXYDE MÉTALLIQUE ET UTILISATION ASSOCIÉE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.06.2013 DE 102013212018**

(43) Veröffentlichungstag der Anmeldung:
**04.05.2016 Patentblatt 2016/18**

(73) Patentinhaber: **Evonik Degussa GmbH**
**45128 Essen (DE)**

(72) Erfinder:
• STEIGER, Jürgen
  111 Taipei City (TW)
• PHAM, Duy Vu
  46149 Oberhausen (DE)
• MERKULOV, Alexey
  45665 Recklinghausen (DE)
• WEBER, Dennis
  44137 Dortmund (DE)

(56) Entgegenhaltungen:
DE-A1-102010 031 592

**Beschreibung**

Die Erfindung betrifft Metalloxid-Prekursoren, sie enthaltende flüssige Beschichtungszusammensetzungen und ihre Verwendung.

Metalloxidische Schichten sind essentiell für viele Anwendungen, insbesondere im Bereich der Halbleitertechnologie. Metalloxidische Schichten lassen sich durch vielfältige Verfahren auf verschiedene Oberflächen aufbringen. Zu diesen Verfahren zählen Vakuumverfahren (Sputtern, chemische Gasphasenabscheidung) und nasschemische Verfahren. Von diesen haben die nasschemischen Verfahren, die auch als Flüssigphasen-Verfahren bezeichnet werden, den Vorteil, dass sie einen geringeren apparativen Aufwand erfordern. Flüssigphasen-Verfahren können mit dispergierten Nanopartikeln oder mit Prekursor-Systemen durchgeführt werden. Dispergierte Nanopartikel haben dabei den Nachteil, dass ihre Herstellung apparativ aufwändig ist und dass die mit ihnen hergestellten Halbleiter-Schichten oft negative Eigenschaften haben.

Aus diesem Grund wird Flüssigphasen-Beschichtungsverfahren, die Prekursoren einsetzen, oft der Vorzug gegeben. Unter einem Metalloxid-Prekursor ist dabei eine thermisch oder mit elektromagnetischer Strahlung zersetzbare Verbindung, mit der in An- oder Abwesenheit von Sauerstoff oder anderen Oxidationsstoffen Metalloxid-haltige Schichten gebildet werden können, zu verstehen.

Im Stand der Technik sind verschiedene Prekursoren zur Herstellung von Metalloxid-Schichten beschrieben. So offenbart WO 2011/020781 A1 Flüssigphasen-Verfahren zur Herstellung Indiumoxid-haltiger Schichten, bei denen Indiumoxoalkoxide eingesetzt werden können, die auch Halogen-, Hydroxy- oder Hydroxyalkoxyreste aufweisen können. Ähnliche Flüssigphasen-Verfahren und Prekursoren, die sich zur Herstellung von Indium-, Gallium-, Zinn-, oder ZinkOxidhaltigen Schichten eignen, werden auch in WO 2011/020792 A1 beschrieben. WO 2012/010427 A1 und DE 10 2010 031 592 A1 offenbaren Halogen-haltige Indiumoxoalkoxide, die sich ebenfalls zur Herstellung von Indiumoxid-haltigen Schichten eignen und die β-Hydroxysäure-Ester-Gruppen aufweisen können. WO 2012/010464 A1 offenbart weiterhin ebenfalls Halogen-haltige Indiumoxoalkoxide, die sich zur Herstellung von Indiumoxid-haltigen Schichten eignen, und die neben Oxo- und Alkoxy-Resten auch Hydroxyl-Gruppen aufweisen können. Den vorgenannten Prekursoren ist gemein, dass sie sich nicht für eine direkte Strukturierung mit UV-Licht eignen.

Strukturierte Schichten, die für vielfältige Anwendungen in der Halbleitertechnik von Interesse sind, können mit diesen Prekursoren nur über den Einsatz von Photolacken hergestellt werden, die einen erhöhten Materialbedarf, eine Vielzahl an zusätzlichen Prozessschritten und einen zusätzlichen Stress für die Oxid-Schicht durch den Kontakt mit aggressiven Materialien zur Folge haben.

Zur direkten Herstellung strukturierter Beschichtungen (z.B. über eine lokale Konvertierung mit Bestrahlung mit elektromagnetischer Strahlung durch eine entsprechende Maske) geeignete Prekursoren, die ausschließlich photovernetzbare Liganden aufweisen, sind jedoch auch nachteilig. So offenbaren z.B. US 2010/0210069 A1 und US 2010/0258793 A1 neben Prekursoren, die sich für die Herstellung von Halbleiter-Schichten geeignete Zink- bzw. Indium-Prekursoren, die Hydroxide, Alkoxide oder aber photovernetzbare (Meth)Acrylatreste aufweisen können. Prekursoren mit ausschließlich photovernetzbaren Liganden haben jedoch den Nachteil, dass sie bei einer höheren Temperatur konvertiert werden müssen und die resultierenden Schichten oft schlechtere elektronische Eigenschaften aufweisen. Weiterhin sind sie in gängigen Lösemitteln nur schlecht löslich.

Es ist somit die Aufgabe der vorliegenden Erfindung, Metalloxid-Prekursoren bereitzustellen, die die im Stand der Technik vorhandenen Nachteile überwinden und die sich insbesondere zur Herstellung von Beschichtungszusammensetzungen für Flüssigphasen-Verfahren eignen.

Diese Aufgabe wird vorliegend gelöst durch den erfindungsgemäßen Metalloxid-Prekursor umfassend

i) mindestens ein Metallatom ausgewählt aus der Gruppe bestehend aus In, Ga, Zn und Sn
ii) mindestens einen nicht photovernetzbaren Liganden und
iii) mindestens einen photovernetzbaren Liganden.

Unter einem "Metallatom" ist dabei im Sinne der vorliegenden Erfindung sowohl ein Metallatom als auch ein Halbmetallatom zu verstehen. Gleiches gilt für die "Metalloxide", bzw. "Metalloxidhaltigen Schichten", die mit ihnen hergestellt werden können. Die erfindungsgemäßen Metalloxid-Prekursoren haben neben der Lösung der erfindungsgemäß gestellten Aufgabe weiterhin den Vorteil, dass sie eine deutlich bessere Löslichkeit in verschiedenen Lösungsmitteln zeigen und bei besonders niedrigen Temperaturen in Metalloxid-haltige Schichten umgewandelt werden können. Die mit ihnen herstellbaren Metalloxidschichten haben weiterhin besonders gute elektrische Eigenschaften.

Nicht photovernetzbare Liganden des Metalloxid-Prekursors sind Liganden, die durch Bestrahlung mit elektromagnetischer Strahlung, insbesondere mit UV-Licht, keine Veränderung erfahren. Bevorzugte nicht photovernetzbare Liganden können ausgewählt werden aus der Gruppe von Resten bestehend aus Oxo-Resten, Hydroxyl-Resten, Alkoxy-Resten, Nitrat-Resten und Halogenid-Resten.

Zur Erzeugung Metalloxid-haltiger Schichten sind weiterhin Oxo-Reste, Hydroxyl-Reste und Alkoxy-Reste besonders geeignet. Besonders gut zur Herstellung Metalloxid-haltiger Schichten geeignete Prekursoren weisen mindestens einen Oxo-Rest und mindestens einen Alkoxy-Rest auf.

Ein besonders gut geeigneter Metalloxid-Prekursor weist als nicht photovernetzbare Liganden ausschließlich Oxo-Reste, Alkoxy-Reste und Reste ausgewählt aus der Gruppe bestehend aus Nitrat-Resten und Halogenid-Resten auf.

Unter einem photovernetzbaren Liganden ist vorliegend ein Rest zu verstehen, der durch Bestrahlung mit elektromagnetischer Strahlung, insbesondere mit UV-Licht mit einem weiteren photovernetzbaren Liganden eines anderen Prekursors quervernetzen kann. Besonders gute Metalloxid-Prekursoren weisen als photovernetzbare Liganden Liganden auf, die ausgewählt werden aus der Gruppe von Resten bestehend aus Acrylat-Resten, Methacrylat-Resten und Allylresten.

Besonders gute Halbleitereigenschaften zeigen weiterhin Schichten aus Metalloxid-Prekursoren, deren Metallatom Indium ist.

Ein ganz besonders bevorzugter Prekursor hat die generische Formel $[In_6(\mu_6\text{-O})(\mu^2\text{-OR})_{12-x}Cl_6(R')_x]^{2-}$ mit R = $C_{1-10}$-Alkyl, R' = Acrylat oder Methacrylat und x = 1 - 10. Unter einem $C_{1-10}$-Alkylrest ist dabei ein Alkylrest mit 1 bis 10 Kohlenstoffatomen zu verstehen.

Ein weiterer ganz besonders bevorzugter Prekursor hat die generische Formel $[In_6(\mu_6\text{-O})(\mu^2\text{-OR})_{12-x}(NO_3)_6(R')_x]^{2-}$ mit R = $C_{1-10}$-Alkyl, R' = Acrylat oder Methacrylat und x = 1 - 10. Unter einem $C_{1-10}$-Alkylrest ist auch hier ein Alkylrest mit 1 bis 10 Kohlenstoffatomen zu verstehen.

Die erfindungsgemäßen Metalloxid-Prekursoren können z.B. durch Zugabe von Verbindungen enthaltend den photovernetzbaren Liganden, insbesondere von Methacrylsäure, Acrylsäure und/oder Allylsäure, zu entsprechenden Metalloxid-Prekursoren mit nicht photovernetzbaren Liganden hergestellt werden, wobei ein partieller Austausch der Liganden erfolgt.

Gegenstand der vorliegenden Erfindung ist weiterhin eine flüssige Beschichtungszusammensetzung, die mindestens einen Prekursor der vorbeschriebenen Art und mindestens ein Lösemittel aufweist.

Weiter bevorzugt enthält sie mindestens einen Photoinitiator.

Besonders bevorzugt ist der Photoinitiator Phenylbis(2,4,6-trimethylbenzoyl)phosphinoxid.

Gegenstand der vorliegenden Erfindung ist weiterhin die Verwendung eines erfindungsgemäßen Prekursors oder einer erfindungsgemäßen Beschichtungszusammensetzung zur Herstellung strukturierter metalloxidischer Schichten.

Gegenstand der vorliegenden Erfindung ist weiterhin ein Verfahren zur Herstellung strukturierter metalloxidischer Schichten, bei dem eine erfindungsgemäße Beschichtungszusammensetzung eingesetzt wird. Dabei wird die erfindungsgemäße Beschichtungszusammensetzung a) auf ein Substrat aufgebracht, b) durch eine Maske mit elektromagnetischer Strahlung bestrahlt, c) ggf. thermisch behandelt, d) mit einem Entwickler behandelt und e) thermisch und/oder mit elektromagnetischer Strahlung konvertiert. Die gemäß b) erfolgende elektromagnetische Bestrahlung erfolgt dabei bevorzugt mit Strahlung einer Wellenlänge von $\lambda$ = 300 - 380 nm. Im Falle einer thermischen Behandlung gemäß Schritt c) bleiben nach dem Entwickeln in Schritt d) nur die nicht belichteten Bereiche zurück. Wird kein thermischer Behandlungsschritt c) durchgeführt, bleiben stattdessen die belichteten Bereiche zurück. Bevorzugt als Entwickler in Schritt d) eingesetzt wird 1-Methoxy-2-Propanol. In Schritt e) erfolgt die Konvertierung der Schicht, d.h. es erfolgt eine Umwandlung in eine metalloxidhaltige Schicht. Eine thermische Konvertierung gemäß Schritt e) erfolgt bevorzugt bei Temperaturen größer als 300 °C, bevorzugt bei 350 °C. Eine Konvertierung mit elektromagnetischer Bestrahlung gemäß Schritt e) erfolgt bevorzugt mit signifikanten Anteilen von Strahlung im Bereich von 170 - 210 nm und von 250 - 258 nm, insbesondere mit UV-Strahlung der Wellenlängen $\lambda$ = 184 nm und 254 nm.

Dabei ist unter Strahlung "mit signifikanten Anteilen von Strahlung im Bereich von 170 - 210 nm und von 250 - 258 nm" Strahlung zu verstehen, deren für diese beiden Wellenlängenbereiche summarisch bestimmte Intensität bezogen auf die zu bestrahlende Probe mindestens 5 mW/cm$^2$ beträgt, mit der Maßgabe, dass dabei auf den intensitätsschwächeren der beiden Bereiche immer eine auf das Substrat bezogene Intensität von mindestens 0,5 mW/cm$^2$ entfällt. Die absoluten Werte können mit verschiedenen im Handel befindlichen Apparaturen direkt und wellenlängenabhängig gemessen werden. Als Beispiel kann das "UV Power Meter C9536" von der Firma Hamamatsu genannt werden.

Bevorzugt, weil dies zu besonders guten elektronischen Eigenschaften führt, erfolgt die Bestrahlung mit elektromagnetischer Strahlung mit signifikanten Anteilen von Strahlung im Bereich von 183 - 187 nm und von 250 - 258 nm, wobei wiederum ein entsprechendes Verständnis des Begriffs "mit signifikanten Anteilen" zu Grunde zu legen ist (die für diese beiden Wellenlängenbereiche summarisch bestimmte Intensität bezogen auf die zu bestrahlende Probe beträgt mindestens 5 mW/cm$^2$, mit der Maßgabe, dass auf den intensitätsschwächeren der beiden Bereiche immer eine auf das Substrat bezogene Intensität von mindestens 0,5 mW/cm$^2$ entfällt.

Besonders gute Ergebnisse werden weiterhin erzielt, wenn die Strahlung mit signifikanten Anteilen von Strahlung im Bereich von 170 - 210 nm und von 250 - 258 nm, noch weiter bevorzugt entsprechende Strahlung mit signifikanten Anteilen im Bereich von 183 - 187 nm und von 250 - 258 nm, in einem hinsichtlich beider Achsen jeweils linear skalierten Intensitäts-Wellenlänge-Spektrum über die gesamte Emission der Lampe mindestens 85 % ihrer Intensität (ermittelt über den prozentualen Anteil der Summe der Integrale der Teilbereiche an der als Integral über alle Wellenlängen des Spektrums ermittelten Gesamtintensität der Strahlung) innerhalb der beiden jeweils genannten Bereichen aufweist.

Entsprechende Strahlung mit signifikanten Anteilen von Strahlung im Bereich von 170 - 210 nm und von 250 - 258 nm kann bevorzugt durch Verwendung von Niederdruck-Quecksilberdampflampen, insbesondere Quarzglas-Niederdruck-Quecksilberdampflampen, erzeugt werden. Eine besonders bevorzugt einsetzbare Quarzglas-Niederdruck-Quecksilberdampflampe ist eine mit dem Leuchtmittel GLF-100 versehene, unter der Handelsbezeichnung Model 144AX-220 erhältliche Lampe der Firma Jelight Company, Inc.

Die nachfolgenden Beispiele sollen den Gegenstand der vorliegenden Erfindung näher erläutern, ohne dabei beschränkend zu wirken.

Die mit den erfindungsgemäßen Prekursoren hergestellten Schichten eignen sich vorteilhaft für die Herstellung leitender, halbleitender oder dielektrischer Schichten, zum Beispiel in TFTs oder Solarzellen. TFTs können vorteilhaft zur aktiven Steuerung von Pixeln in LCDs eingesetzt werden. Eine andere Anwendung sind Schaltkreise aus TFTs, z.B. zur Realisierung von RFID-Etiketten.

**Beispiel 1**

Synthese von $[In_6(\mu_6\text{-O})(\mu^2\text{-OR})_{12-x}Cl_6(R')_x]^{2-}$ mit R' = Methacrylat

50 mg $[In_6(\mu_6\text{-O})(\mu_2\text{-OMe})_{12}Cl_6]^{2-}[NH_2Me_2]^{2+}(MeOH)_2$ wurde in 1 mL 1-Methoxy-2-propanol (wasserfrei) gelöst. Dann wurden 26 mg Methacrylsäure zugegeben und die Mischung wurde bei Raumtemperatur 10 Minuten gerührt. Die resultierende Mischung wurde zentrifugiert, das Zentrifugat eingedampft und getrocknet.

Herstellung der Beschichtungszusammensetzung

Der erhaltene Feststoff wurde in 1-Methoxy-2-propanol gelöst, so dass eine Lösung mit einer Konzentration von 100 mg/mL in Bezug auf den Prekursor entstand. Als Photoinitiator wurden 8 Gew.-% Irgacure 819 (Phenylbis(2,4,6-trimethylbenzoyl)phosphinoxid) zugesetzt. Diese Lösung wurde anschließend im Volumenverhältnis von 1:2 mit 1-Methoxy-2-propanol verdünnt.

Herstellung strukturierter Schichten

Die Lösung wurde mittels Spin-Coating auf ein Substrat aufgebracht und anschließend mit Hilfe einer Maske selektiv an einem Mask-Aligner mit UV-Licht der Wellenlänge $\lambda$ = 365 nm belichtet. Bei der nachfolgenden Entwicklung wurden die unbelichteten Stellen mit einem Entwickler (1-Methoxy-2-Propanol) entfernt. Zurück blieben die unbelichteten Stellen. Die erhaltenen Strukturen wurden mittels einer UVO-Behandlung mit Strahlung der Wellenlänge $\lambda$ = 184 nm und 254 nm und thermische Umsetzung bei 350 °C in Indiumoxid-haltige Strukturen umgewandelt.

**Beispiel 2**

Synthese von $[In_6(\mu_6\text{-O})(\mu^2\text{-OR})_{12-x}(NO_3)_6(R')_x]^{2-}$ mit R' = Methacrylat

50 mg $[In_6(\mu_6\text{-O})(\mu_2\text{-OMe})_{12}(NO_3)_6]^{2-}[NH_2Me_2]^{2+}(MeOH)_2$ wurde in 1 mL 1-Methoxy-2-propanol (wasserfrei) gelöst. Dann wurden 26 mg Methacrylsäure zugegeben und die Mischung wurde bei Raumtemperatur 10 Minuten gerührt. Die resultierende Mischung wurde zentrifugiert, das Zentrifugat eingedampft und getrocknet.

Herstellung der Beschichtungszusammensetzung

Der erhaltene Feststoff wurde in 1-Methoxy-2-propanol gelöst, so dass eine Lösung mit einer Konzentration von 100 mg/mL in Bezug auf den Prekursor entstand. Als Photoinitiator wurden 8 Gew.-% Irgacure 819 (Phenylbis(2,4,6-trimethylbenzoyl)phosphinoxid) zugesetzt. Diese Lösung wurde anschließend im Volumenverhältnis von 1:2 mit 1-Methoxy-2-propanol verdünnt.

Herstellung strukturierter Schichten

Die Lösung wurde mittels Spin-Coating auf ein Substrat aufgebracht und anschließend mit Hilfe einer Maske selektiv an einem Mask-Aligner mit UV-Licht der Wellenlänge $\lambda$ = 365 nm belichtet. Bei der nachfolgenden Entwicklung wurden die unbelichteten Stellen mit einem Entwickler (1-Methoxy-2-Propanol) entfernt. Zurück blieben die unbelichteten Stellen. Die erhaltenen Strukturen wurden mittels einer UVO-Behandlung mit Strahlung der Wellenlänge $\lambda$ = 184 nm und 254 nm und thermische Umsetzung bei 350 °C in Indiumoxid-haltige Strukturen umgewandelt.

**Vergleichsbeispiele**

Synthese eines ausschließlich photovernetzbare Gruppen aufweisenden Prekursors

Es wurden 25 mg In(III)isopropoxid (Hersteller: Alfa Aesar) pro 1 mL Methacrylsäure gelöst. Die Mischung wurde 1 h bei 100°C unter Rückfluss gekocht. Die resultierende Mischung wurde zentrifugiert, das Zentrifugat eingedampft und getrocknet. NMR-Messungen zeigen ausschließlich Methacrylatgruppen, also photovernetzbare Liganden.

Herstellung der Beschichtungszusammensetzung

Der erhaltene Rückstand wurde in 1-Methoxy-2-propanol gelöst, so dass eine Lösung mit einer Konzentration von 33 mg/mL in Bezug auf den Prekursor entstand. Als Photoinitiator wurden 8 Gew.-% Irgacure 819 (Phenylbis(2,4,6-trimethylbenzoyl)phosphinoxid) zugesetzt.

Herstellung strukturierter Schichten

Die Lösung wurde mittels Spin-Coating auf ein Substrat aufgebracht und anschließend mit Hilfe einer Maske selektiv an einem Mask-Aligner mit UV-Licht der Wellenlänge $\lambda$ = 365 nm belichtet. Bei der nachfolgenden Entwicklung wurden die unbelichteten Stellen mit einem Entwickler (1-Methoxy-2-Propanol) entfernt. Zurück blieben die unbelichteten Stellen. Die erhaltenen Strukturen wurden mittels einer UVO-Behandlung mit Strahlung der Wellenlängen $\lambda$ = 184 nm und 254 nm und thermische Umsetzung bei 350 °C bzw. 550 °C in Indiumoxid-haltige Strukturen umgewandelt.

In beiden Beispielen wurde die Schichtherstellung über Spin Coating mit den folgenden Parametern durchgeführt: 100 $\mu$l Beschichtungszusammensetzung wurden mit 3.000 rpm über 30 s auf einen Siliciumwafer mit einer 230 nm dicken $SiO_2$-Schicht und vorstrukturierten Source-und Drain-Kontakten aus ITO aufgebracht. Die thermische Konvertierung erfolgte auf einer Heizplatte.

Die elektrische Charakterisierung erfolgte in beiden Fällen mit einem Keithley 2612 System Sourcemeter mit Keithley 3706-NFP System switch/multimeter. Die Proben wurden unter $N_2$-Atmosphäre bei Raumtemperatur vermessen. Die Charakterisierung fand im Anschluss an die Temperaturbehandlung statt. Dabei wurden die (vorstrukturierten) Gate-, Source- und Drainkontakte mit dem Gerät über Wolfram-Messspitzen verbunden. Zwischen Gate- und Source-Elektrode wurde ein Spannungsprofil zwischen - 20 und +30 V durchfahren und der zwischen Source- und Drainelektrode fließende Strom aufgezeichnet. Mit Hilfe dieser Daten lassen sich die Mobilitätswerte gemäß

$$\mu_{lin} = \frac{\partial I_D}{\partial V_G} \frac{L}{W C_i V_D}$$

$$\mu_{sat} = \frac{2L}{W C_i} \left( \frac{\partial \left( \sqrt{I_D} \right)}{\partial V_G} \right)^2$$

berechnen, wobei $I_D$ und $V_G$ der Strom zwischen Drain und Source bzw. die am Gate angelegte Spannung ist. L und W entsprechen der Länge bzw. der Weite des Kanals und $C_i$ ist die Dielektrizitätskonstante des Dielektrikums. Je höher der Wert für die Mobilität, desto besser ist das Material.

Weitere charakteristische Eigenschaften sind die Einschaltspannung ($V_{ON}$), welche den Punkt beschreibt, ab dem der Stromfluss zwischen Source- und Drain-Elektrode einsetzt; dieser Wert sollte möglichst nahe bei 0 V liegen. $I_{ON}$ ist der maximale Stromfluss zwischen Source- und Drain-Elektrode (hier gemessen bei einer Gate-Spannung von 30 V); dieser Wert sollte möglichst hoch sein. Das Verhältnis ($I_{ON}/I_{OFF}$) beschreibt das Verhältnis zwischen $I_{ON}$ und dem Stromfluss im ausgeschalteten Zustand (unterhalb von $V_{ON}$); dieser Wert sollte möglichst hoch sein.

Die nachfolgend dargestellte Tabelle fasst die Daten der elektrischen Charakterisierung zusammen.

Tabelle:

| Material | $T_{anneal}$ [°C] | $V_{On}$ [V] | $I_{On}$ [mA] | $I_{On}/I_{Off}$ | $\mu_{lin}$ [cm$^2$/Vs] | $\mu_{sat}$ [cm$^2$/Vs] |
|---|---|---|---|---|---|---|
| Mischligand Bsp. 1 | 350 | -0,5 | 0,55 | 6 x 10$^6$ | 3,08 | 1,12 |
| Mischligand Bsp. 2 | 350 | 0,5 | 0,4 | 6 x 10$^6$ | 2,24 | 0,82 |

(fortgesetzt)

| Material | $T_{anneal}$ [°C] | $V_{On}$ [V] | $I_{On}$ [mA] | $I_{On}/I_{Off}$ | $\mu_{lin}$ [cm$^2$/Vs] | $\mu_{sat}$ [cm$^2$/Vs] |
|---|---|---|---|---|---|---|
| Methacrylat | 350 | 4 | $2{,}8 \times 10^{-3}$ | $1{,}6 \times 10^4$ | 0,013 | 0,014 |

**Patentansprüche**

1. Metalloxid-Prekursor umfassend

   i) mindestens ein Metallatom ausgewählt aus der Gruppe bestehend aus In, Ga, Zn und Sn
   ii) mindestens einen nicht photovernetzbaren Liganden und
   iii) mindestens einen photovernetzbaren Liganden.

2. Prekursor nach Anspruch 1,
**dadurch gekennzeichnet, dass**
der mindestens eine nicht photovernetzbare Ligand ausgewählt wird aus der Gruppe von Resten bestehend aus Oxo-Resten, Hydroxyl-Resten, Alkoxy-Resten, Nitrat-Resten und Halogenid-Resten.

3. Prekursor nach Anspruch 2,
**dadurch gekennzeichnet, dass**
er als mindestens einen nicht photovernetzbaren Liganden mindestens einen Oxo-Rest und mindestens einen Alkoxy-Rest aufweist.

4. Prekursor nach einem der vorhergehenden Ansprüche,
**dadurch gekennzeichnet, dass**
er als nicht photovernetzbare Liganden ausschließlich Oxo-Reste, Alkoxy-Reste und Reste ausgewählt aus der Gruppe bestehend aus Nitrat-Resten und Halogenid-Restenaufweist.

5. Prekursor nach einem der vorhergehenden Ansprüche,
**dadurch gekennzeichnet, dass**
der mindestens eine photovernetzbare Ligand ausgewählt wird aus der Gruppe von Resten bestehend aus Acrylat-Resten, Methacrylat-Resten und Allylresten.

6. Prekursor nach einem der vorhergehenden Ansprüche,
**dadurch gekennzeichnet, dass**
das mindestens eine Atom In ist.

7. Prekursor nach einem der vorhergehenden Ansprüche,
**dadurch gekennzeichnet, dass**
er die generische Formel $[In_6(\mu_6\text{-O})(\mu^2\text{-OR})_{12-x}Cl_6(R')_x]^{2-}$ mit R = C$_{1-10}$-Alkyl, R' = Acrylat oder Methacrylat und x = 1-10 hat.

8. Prekursor nach einem der vorhergehenden Ansprüche,
**dadurch gekennzeichnet, dass**
er die generische Formel $[In_6(\mu_6\text{-O})(\mu^2\text{-OR})_{12-x}(NO_3)_6(R')_x]^{2-}$ mit R = C$_{1-10}$-Alkyl, R' = Acrylat oder Methacrylat und x = 1-10 hat.

9. Flüssige Beschichtungszusammensetzung umfassend

   a. mindestens einen Prekursor nach einem der Ansprüche 1 bis 8 und
   b. mindestens ein Lösemittel.

10. Beschichtungszusammensetzung nach Anspruch 9,
**dadurch gekennzeichnet, dass**
sie weiterhin mindestens einen Photoinitiator umfasst.

**11.** Beschichtungszusammensetzung nach Anspruch 10,
**dadurch gekennzeichnet, dass**
der Photoinitiator Phenylbis(2,4,6-trimethylbenzoyl)phosphinoxid ist.

**12.** Verwendung eines Prekursors nach einem der Ansprüche 1 bis 8 oder einer Beschichtungszusammensetzung nach einem der Ansprüche 9 bis 11 zur Herstellung strukturierter metalloxidischer Schichten.

**Claims**

**1.** Metal oxide precursor comprising

    i) at least one metal atom selected from the group consisting of In, Ga, Zn and Sn,
    ii) at least one non-photocrosslinkable ligand and
    iii) at least one photocrosslinkable ligand.

**2.** Precursor according to Claim 1,
**characterized in that**
the at least one non-photocrosslinkable ligand is selected from the group of radicals consisting of oxo radicals, hydroxyl radicals, alkoxy radicals, nitrate radicals and halide radicals.

**3.** Precursor according to Claim 2,
**characterized in that**
it comprises as at least one non-photocrosslinkable ligand at least one oxo radical and at least one alkoxy radical.

**4.** Precursor according to any of the preceding claims,
**characterized in that**
it has as non-photocrosslinkable ligands exclusively oxo radicals, alkoxy radicals and radicals selected from the group consisting of nitrate radicals and halide radicals.

**5.** Precursor according to any of the preceding claims,
**characterized in that**
the at least one photocrosslinkable ligand is selected from the group of radicals consisting of acrylate radicals, methacrylate radicals and allyl radicals.

**6.** Precursor according to any of the preceding claims,
**characterized in that**
the at least one atom is In.

**7.** Precursor according to any of the preceding claims,
**characterized in that**
it has the generic formula $[In_6(\mu_6\text{-}O)(\mu^2\text{-}OR)_{12}\text{-}xCl_6(R')_x]^{2-}$ with R = $C_{1\text{-}10}$ alkyl, R' = acrylate or methacrylate and x = 1-10.

**8.** Precursor according to any of the preceding claims,
**characterized in that**
it has the generic formula $[In_6(\mu_6\text{-}O)(\mu^2\text{-}OR)_{12\text{-}x}(NO_3)_6(R')_x]^{2-}$ with R = $C_{1\text{-}10}$ alkyl, R' = acrylate or methacrylate and x = 1-10.

**9.** Liquid coating composition comprising

    a. at least one precursor according to any of Claims 1 to 8 and
    b. at least one solvent.

**10.** Coating composition according to Claim 9,
**characterized in that**
it further comprises at least one photoinitiator.

11. Coating composition according to Claim 10,
    **characterized in that**
    the photoinitiator is phenylbis(2,4,6-trimethylbenzoyl)phosphine oxide.

12. Use of a precursor according to any of Claims 1 to 8 or of a coating composition according to any of Claims 9 to 11 for producing structured metal-oxidic layers.

**Revendications**

1. Précurseur d'oxyde métallique, comprenant :

   i) au moins un atome métallique choisi dans le groupe constitué par In, Ga, Zn et Sn,
   ii) au moins un ligand non photoréticulable, et
   iii) au moins un ligand photoréticulable.

2. Précurseur selon la revendication 1, **caractérisé en ce que** ledit au moins un ligand non photoréticulable est choisi dans le groupe de radicaux constitué par les radicaux oxo, les radicaux hydroxyle, les radicaux alcoxy, les radicaux nitrate et les radicaux halogénure.

3. Précurseur selon la revendication 2, **caractérisé en ce qu'**il comprend en tant qu'au moins un ligand non photoréticulable au moins un radical oxo et au moins un radical alcoxy.

4. Précurseur selon l'une quelconque des revendications précédentes, **caractérisé en ce qu'**il comprend en tant que ligand non photoréticulable exclusivement des radicaux oxo, des radicaux alcoxy et des radicaux choisis dans le groupe constitué par les radicaux nitrate et les radicaux halogénure.

5. Précurseur selon l'une quelconque des revendications précédentes, **caractérisé en ce que** ledit au moins un ligand photoréticulable est choisi dans le groupe de radicaux constitué par les radicaux acrylate, les radicaux méthacrylate et les radicaux allyle.

6. Précurseur selon l'une quelconque des revendications précédentes, **caractérisé en ce qu'**au moins un atome est In.

7. Précurseur selon l'une quelconque des revendications précédentes, **caractérisé en ce qu'**il a la formule générique $[In_6(\mu_6\text{-O})(\mu^2\text{-OR})_{12-x}Cl_6(R')_x]^{2-}$ avec R = alkyle en $C_{1-10}$, R' = acrylate ou méthacrylate et x = 1 à 10.

8. Précurseur selon l'une quelconque des revendications précédentes, **caractérisé en ce qu'**il a la formule générique $[In_6(\mu_6\text{-O})(\mu^2\text{-OR})_{12-x}(NO_3)_6(R')_x]^{2-}$ avec R = alkyle en $C_{1-10}$, R' = acrylate ou méthacrylate et x = 1 à 10.

9. Composition de revêtement liquide, comprenant :

   a. au moins un précurseur selon l'une quelconque des revendications 1 à 8 et
   b. au moins un solvant.

10. Composition de revêtement selon la revendication 9, **caractérisée en ce qu'**elle comprend en outre au moins un photoinitiateur.

11. Composition de revêtement selon la revendication 10, **caractérisée en ce que** le photoinitiateur est l'oxyde de phénylbis(2,4,6-triméthylbenzoyl)phosphine.

12. Utilisation d'un précurseur selon l'une quelconque des revendications 1 à 8 ou d'une composition de revêtement selon l'une quelconque des revendications 9 à 11 pour la fabrication de couches d'oxyde métallique structurées.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2011020781 A1
- WO 2011020792 A1
- WO 2012010427 A1
- DE 102010031592 A1
- WO 2012010464 A1
- US 20100210069 A1
- US 20100258793 A1